(19) Europäisches Patentamt
European Patent Office
Office européen des brevets

(11) EP 2 041 586 B1

(12) FASCICULE DE BREVET EUROPEEN

(45) Date de publication et mention de la délivrance du brevet:
06.04.2016 Bulletin 2016/14

(51) Int Cl.:
*G01R 29/12* (2006.01)    *G01W 1/16* (2006.01)

(21) Numéro de dépôt: 07823288.1

(22) Date de dépôt: 16.07.2007

(86) Numéro de dépôt international:
PCT/FR2007/001218

(87) Numéro de publication internationale:
WO 2008/009807 (24.01.2008 Gazette 2008/04)

(54) **DISPOSITIF DE DETECTION D'ORAGE**

STURMERKENNNUNGSVORRICHTUNG

STORM DETECTION DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **17.07.2006 FR 0606484**

(43) Date de publication de la demande:
**01.04.2009 Bulletin 2009/14**

(73) Titulaire: **Franklin France 2F**
**77330 Ozoir-La-Ferriere (FR)**

(72) Inventeur: **FULCHIRON, Odile**
**75013 Paris (FR)**

(74) Mandataire: **Laget, Jean-Loup**
**Brema-Loyer**
**Le Centralis**
**63 avenue du Général Leclerc**
**92340 Bourg-la-Reine (FR)**

(56) Documents cités:
**FR-A- 1 400 352    FR-A1- 2 322 377**

**Description**

La présente invention a pour objet un dispositif de détection d'orage.

Dans de nombreux cas où la foudre présente un danger pour des personnes ou des équipements, la connaissance de la probabilité d'un orage peut permettre de prendre les précautions appropriées. Ceci peut se produire par exemple lorsque des personnes sont amenées à travailler sur des installations non pourvues d'équipements de protection contre la foudre, lorsque des explosifs sont manipulés à des fins civiles ou militaires, pendant des opérations de manipulation de combustibles liquides tels que le mazout ou l'essence, lorsque des appareils électroniques ne peuvent pas être complètement protégés des surtensions créées par la foudre, etc.

Pour détecter un orage, il a été proposé, notamment, des dispositifs de mesure d'ondes radioélectriques, des radars météorologiques et des dispositifs de mesure du champ électrostatique atmosphérique.

Par beau temps, le champ électrostatique atmosphérique, orienté verticalement et qui peut être positif ou négatif, est de l'ordre de 100 à 150V/m. A l'approche d'un nuage orageux chargé électriquement, le champ électrostatique atmosphérique s'inverse puis croît brusquement pour atteindre une valeur, positive ou négative, allant d'environ 10 kV/m à plusieurs centaines de kV/m selon le profil géographique local et l'altitude.

Le document FR 2 432 719 décrit un dispositif de détection d'orage comportant un appareil de mesure du champ électrostatique atmosphérique du type moulin à champ. Le dispositif comporte un écran rotatif apte à soumettre une première paire d'électrodes de mesure au champ électrostatique atmosphérique pendant qu'une deuxième paire d'électrodes de mesure est isolée du champ électrostatique atmosphérique, puis à isoler la première paire d'électrode du champ électrostatique atmosphérique pendant que la deuxième paire d'électrode est soumise au champ électrostatique atmosphérique. L'amplitude de la tension alternative aux bornes des électrodes est mesurée puis comparée à un seuil de tension. Lorsque l'amplitude dépasse le seuil de tension une alarme est générée. L'écran rotatif comporte deux disques, sensiblement de mêmes aires que les plateaux des électrodes, réunis par un bras.

Ce dispositif présente l'inconvénient que le signal modulé obtenu en sortie des électrodes a une forme complexe, ce qui complique le traitement du signal. De plus, les électrodes sont particulièrement exposées à des perturbations extérieures, telles que la pluie, la grêle, la neige ou la poussière, par exemple. Le document FR 1400352 décrit un dispositif d'enregistrement de l'intensité du champ électrique terrestre.

La présente invention a pour but de proposer un dispositif de détection d'orage qui évite au moins certains des inconvénient précités, qui soit robuste et qui permette de faciliter le traitement du signal.

A cet effet, l'invention a pour objet un dispositif de détection d'orage comportant au moins une paire d'électrodes de mesure du champ électrostatique atmosphérique, un écran rotatif, apte à soumettre simultanément chaque électrode de ladite au moins une paire d'électrodes au champ électrostatique atmosphérique puis à isoler simultanément chaque électrode de ladite au moins une paire d'électrodes du champ électrostatique atmosphérique, et une unité centrale apte à traiter des signaux provenant desdites électrodes pour déterminer un éventuel risque d'orage, caractérisé en ce que ledit écran rotatif comporte un disque présentant des lumières aptes à découvrir lesdites électrodes pendant une portion d'une révolution dudit écran rotatif pour les soumettre au champ électrostatique atmosphérique.

Avantageusement, la forme de chacune desdites lumières est telle que le signal provenant d'au moins une électrode de mesure lors de la rotation dudit écran rotatif est sensiblement sinusoïdal.

Selon un mode de réalisation de l'invention, au moins une lumière a une forme sensiblement arrondie.

De préférence, la projection d'au moins une électrode dans le plan dudit écran rotatif a une forme sensiblement arrondie, le rapport entre le rayon de ladite lumière et le rayon de ladite projection étant compris entre 1,20 et 1,30.

Avantageusement, au moins une électrode a sensiblement la forme d'un cône dont le sommet est dirigé vers ledit écran rotatif.

Selon un mode de réalisation de l'invention, l'angle du cône est compris entre 150° et 180°.

Selon un mode de réalisation de l'invention, le dispositif comporte une platine et plusieurs paires d'électrodes disposées en cercle sur ladite platine, deux électrodes d'une paire d'électrodes étant diamétralement opposées et connectées électriquement.

Avantageusement, ladite platine a la forme d'un cône dont le sommet est dirigé vers ledit écran rotatif.

De préférence, ladite platine comporte une rainure annulaire s'étendant le long de la base du cône.

Avantageusement, le dispositif comporte un cylindre de protection entourant lesdites électrodes et ledit écran rotatif.

Selon un mode de réalisation de l'invention, un espace est prévu entre ledit cylindre de protection et ladite platine pour permettre l'écoulement d'eau.

Avantageusement, ledit cylindre de protection comporte une collerette en forme de portion de tore, le rapport entre le diamètre du tore et le diamètre intérieur dudit cylindre de protection étant compris entre 0,18 et 0,30.

De préférence, le dispositif comporte un dispositif de chauffage disposé dans ladite collerette.

Selon un mode de réalisation de l'invention, ledit dispositif comporte six paires d'électrodes.

De préférence, ledit écran rotatif comporte six lumières disposées en cercle de manière à pouvoir découvrir simultanément trois paires d'électrodes.

Avantageusement, ledit écran rotatif est entraîné en rotation par un moteur comportant des capteurs à effet Hall.

L'invention sera mieux comprise, et d'autres buts, détails, caractéristiques et avantages de celle-ci apparaîtront plus clairement au cours de la description explicative détaillée qui va suivre, d'un mode de réalisation de l'invention donné à titre d'exemple purement illustratif et non limitatif, en référence aux dessins schématiques annexés.

Sur ces dessins :

- la figure 1 est une vue schématique simplifiée en coupe longitudinale d'un dispositif de détection d'orage selon un mode de réalisation de l'invention ;

- la figure 2 est une vue schématique simplifiée de dessus d'une platine et d'électrodes du dispositif de détection d'orage de la figure 1 ;

- la figure 3 est une vue schématique simplifiée en coupe longitudinale d'une électrode de la figure 2 ;

- la figure 4 est une vue schématique simplifiée de dessus d'un écran rotatif du dispositif de détection d'orage de la figure 1 ;

- la figure 5 est une vue schématique fonctionnelle d'un moteur du dispositif de détection d'orage de la figure 1 ;

- la figure 6 est une vue schématique simplifiée en coupe longitudinale de la platine de la figure 2 ;

- la figure 7 est une vue schématique simplifiée en coupe longitudinale d'un cylindre de protection du dispositif de détection d'orage de la figure 1 ;

- la figure 8 est une vue schématique simplifiée partielle en coupe longitudinale montrant une excroissance annulaire du cylindre de protection de la figure 7 ; et

- la figure 9 est une vue schématique simplifiée en perspective montrant l'écran rotatif de la figure 4 et le cylindre de protection de la figure 7.

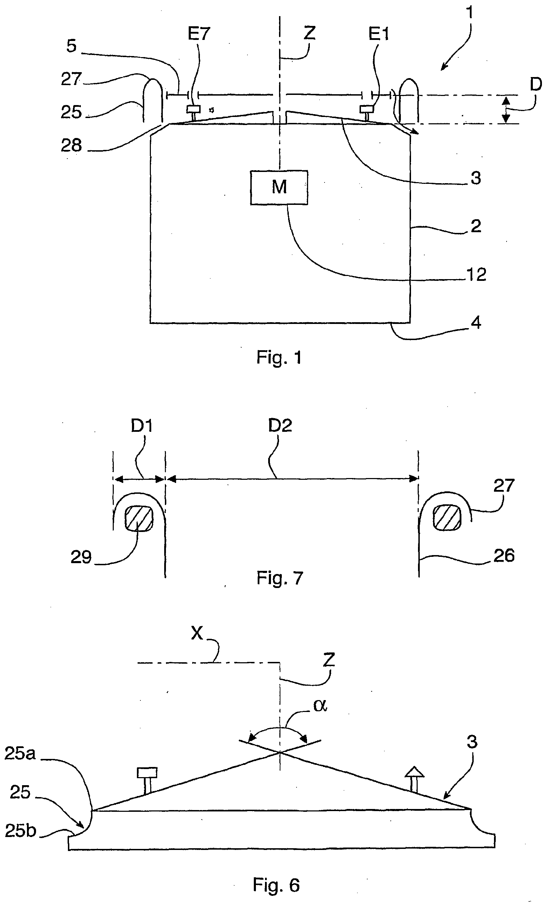

La figure 1 montre un dispositif de détection d'orage 1 comportant une enveloppe cylindrique 2, par exemple réalisée en métal inoxydable. L'axe longitudinal de l'enveloppe 2 est sensiblement parallèle à une direction Z, dite verticale. L'enveloppe 2 est fermée à sa partie supérieure par une platine 3, par exemple en métal inoxydable, et à sa partie inférieure par un fond 4, par exemple en métal inoxydable.

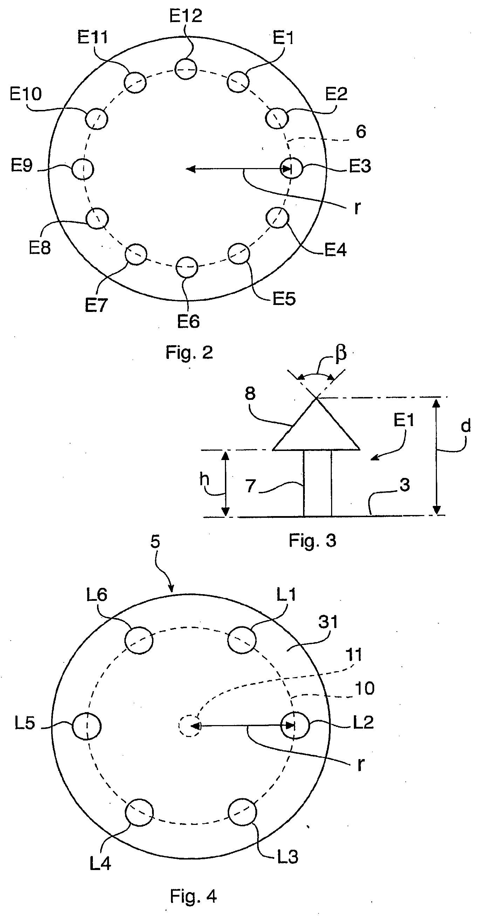

Le dispositif 1 comporte des moyens de mesure du champ électrostatique atmosphérique, comprenant un ensemble d'électrodes E. L'ensemble d'électrodes E comprend par exemple douze électrodes $E_1$, $E_2$, $E_3$, $E_4$, $E_5$, $E_6$, $E_7$, $E_8$, $E_9$, $E_{10}$, $Z_{11}$, et $E_{12}$, disposées sur la face supérieure de la platine 3 de manière régulière selon un cercle 6 de rayon r, représenté en traits interrompus sur la figure 2. Les électrodes $E_1$ à $E_{12}$ sont suffisamment écartées les unes des autres pour éviter qu'une goutte d'eau, un grêlon, ou tout autre élément conducteur susceptible d'être amené entre elles ne puisse les court-circuiter. Deux électrodes $E_1$ et $E_7$ (respectivement $E_2$ et $E_8$, $E_3$ et $E_9$, $E_4$ et $E_{10}$, $E_5$ et $E_{11}$, $E_6$ et $E_{12}$) disposées face-à-face sont connectées électriquement entre elles et forment une paire d'électrodes. L'ensemble d'électrodes E comporte donc six paires d'électrodes. On notera que ce nombre n'est pas limitatif. L'électrode $E_1$ va maintenant être décrite plus en détails, en référence à la figure 3. Les électrodes $E_2$ à $E_{12}$ sont réalisées de manière similaire. L'électrode $E_1$ comporte un pied isolant 7 et une tête 8. Le pied 7 est fixé à la platine 3 et sa hauteur h est suffisante pour éviter qu'une pellicule d'eau ou un dépôt de poussières conductrices sur la platine 3 ne puisse court-circuiter la tête 8. Par exemple la hauteur h est telle que la distance d entre la platine 3 et le sommet de la tête 8 soit d'environ 23mm. La tête 8 est par exemple réalisée en métal inoxydable.

L'électrode $E_1$ présente une symétrie de révolution, sans que cette caractéristique soit essentielle pour la réalisation de l'invention. La connexion de l'électrode $E_1$ avec les moyens d'alimentation 30 et l'unité centrale est par exemple réalisée à l'aide d'un fil conducteur (non représenté) disposé à l'intérieur du pied isolant 7. La tête 8 de l'électrode $E_1$ présente une face supérieure de forme conique formant un angle au sommet β, qui est par exemple compris entre 150° et 180°, de préférence entre 162° et 166°. Le sommet du cône est dirigé vers un écran rotatif 5 du dispositif 1. La forme conique de la tête 8 favorise notamment l'évacuation d'eau et permet de minimiser le risque de court-circuit entre l'électrode $E_1$ et l'écran 5, qui pourrait être dû à des gouttes d'eau de condensation.

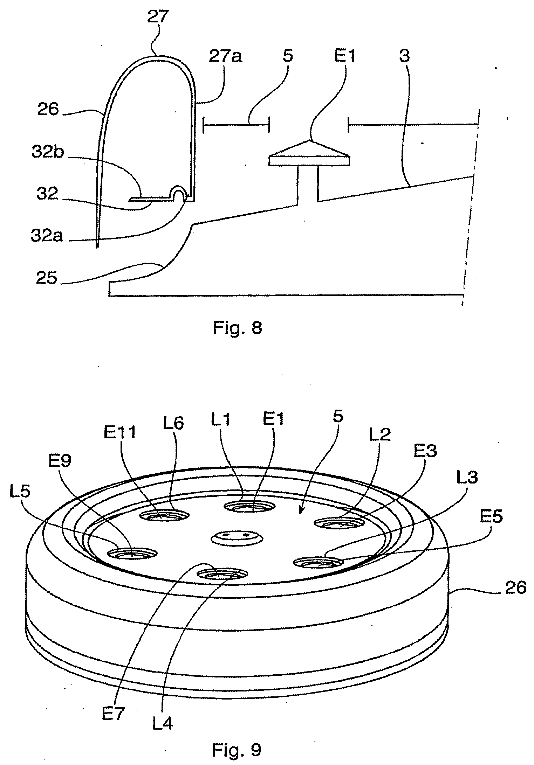

L'écran rotatif 5 (figures 4 et 9) comporte un disque 31, par exemple réalisé en métal inoxydable ou tout autre matière conductrice. L'écran rotatif 5 est disposé dans un plan sensiblement parallèle au plan de la platine 3, à distance des têtes 8 des électrodes $E_1$ à $E_{12}$. Par exemple, la distance D (figure 1) entre la platine 3 et l'écran 5 est d'environ 24mm, ce qui équivaut à une distance d'environ 1mm entre l'écran 5 et le sommet des têtes 8 des électrodes $E_1$ à $E_{12}$. Le disque 31 présente un ensemble de lumières L, disposées de manière régulière selon un cercle 10, représenté en traits interrompus sur la figure 4, de même rayon r que le cercle 6. Chaque lumière L a par exemple une forme sensiblement arrondie. Le nombre de lumières L est égal à la moitié du nombre d'électrodes E, c'est-à-dire que, dans l'exemple, le disque 31 présente six lumières $L_1$, $L_2$, $L_3$, $L_4$, $L_5$ et $L_6$. Ainsi, lorsque l'électrode $E_1$ se trouve au droit d'une lumière L, par exemple la lumière $L_1$, les électrodes $E_3$, $E_5$, $E_7$, $E_9$ et $E_{11}$ se trouvent simultanément au droit des

lumières $L_2$, $L_3$, $L_4$, $L_5$ et $L_6$, respectivement. En d'autres termes, les trois paires d'électrodes $E_1$ et $E_7$, $E_3$ et $E_9$, $E_5$ et $E_{11}$ sont aptes à être découvertes simultanément par l'écran 5 pour être soumises au champ électrostatique. Dans la suite de la description, les trois paires d'électrodes $E_1$ et $E_7$, $E_3$ et $E_9$, $E_5$ et $E_{11}$ sont appelées premier groupe d'électrodes E. De manière similaire, les trois paires d'électrodes $E_2$ et $E_8$, $E_4$ et $E_{10}$, $E_6$ et $E_{12}$ sont aptes à être découvertes simultanément par l'écran 5 pour être soumises au champ électrostatique. Les trois paires d'électrodes $E_2$ et $E_8$, $E_4$ et $E_{10}$, $E_6$ et $E_{12}$ sont appelées deuxième groupe d'électrodes E. On notera que, lorsque les électrodes E d'un groupe d'électrodes E sont découvertes, les électrodes E de l'autre groupe d'électrodes E sont couvertes par l'écran 5, c'est-à-dire qu'elles sont isolées du champ électrostatique atmosphérique.

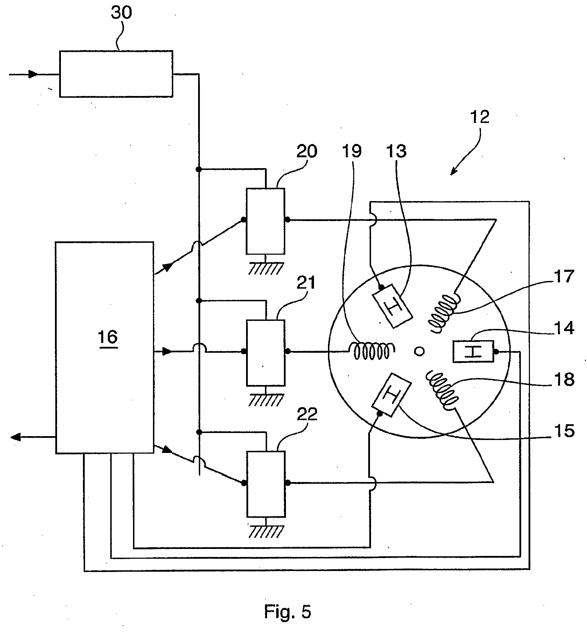

L'écran 5 comporte un pied 11 solidaire de l'arbre (non représenté) d'un moteur 12 (figure 5) du dispositif 1. Le moteur 12 est par exemple un moteur triphasé à huit pôles. Le moteur 12 comporte des capteurs à effet Hall 13, 14 et 15 qui permettent de détecter la position du rotor du moteur 12. Le moteur 12 comporte un boîtier de commande 16 apte à commander la commutation du courant dans des enroulements 17, 18 et 19, par le biais de commutateurs 20, 21 et 22. Le pilotage électronique présente l'avantage d'une bonne régulation de la vitesse de rotation. Il permet en outre de protéger le moteur 12 des effets d'un blocage de l'écran 5, même pendant de longues périodes. Après un blocage, le redémarrage est automatique.

On notera que, l'écran 5 étant solidaire de l'arbre du moteur 12, la détection de la position du rotor du moteur 12 permet de déterminer la position de l'écran 5, c'est-à-dire la position des lumières L par rapport aux électrodes E. Par le pilotage électronique, en utilisant l'effet Hall et les phases, il est possible d'identifier électroniquement la position de l'arbre du moteur 12 et, par voie de conséquence, celle de l'écran 5. Il n'est donc pas nécessaire de disposer d'un capteur supplémentaire pour déterminer la position de l'écran 5.

La platine 3 présente une forme conique d'angle $\alpha$ (figure 6), qui est par exemple compris entre 160° et 190°, de préférence entre 172° et 176°. Le sommet du cône est dirigé vers l'écran 5. La base du cône se prolonge par une rainure annulaire 25 de section arrondie, de manière que le bord 25a de la rainure 25 situé contre la base du cône s'étende sensiblement dans la direction Z et que le bord opposé 25b de la rainure 25 s'étende sensiblement dans une direction X, dite horizontale. La forme conique et le profil de la rainure 25 ont notamment pour fonction de favoriser l'écoulement d'eau.

Le dispositif 1 comporte un cylindre protecteur 26 (figures 1, 7 et 8) entourant les électrodes E et l'écran rotatif 5. Le cylindre 26 présente le même axe de révolution que l'enveloppe 2. Une fonction du cylindre 26 est d'assurer la protection mécanique de l'écran 5 et des électrodes E.

Le cylindre protecteur 26 comporte une collerette 27. La collerette 27 présente une forme de demi-tore. En variante, la collerette 27 présente une forme de tore. De manière générale, la collerette 27 présente une forme de portion de tore, le rapport entre le diamètre $D_1$ du tore et le diamètre intérieur $D_2$ du cylindre 26 étant par exemple compris entre 18% et 30%. Cette forme permet, selon le théorème de Rodowski, de minimiser la perturbation des lignes de champ électrostatique au voisinage de la collerette 27. La collerette 27 est disposée au droit de la rainure 25. Un espace 28 est ménagé entre la base du cylindre 26 et la platine 3 de manière à permettre l'écoulement de l'eau de pluie. La collerette 27 permet également de bloquer des projections d'eau en provenance de l'écran 5, ce qui évite une pulvérisation au voisinage du dispositif 1, susceptible de perturber le champ mesuré. L'extrémité inférieure du bord intérieur 27a de la collerette 27 présente une excroissance annulaire 32 faisant saillie radialement vers l'intérieur de la collerette 27, c'est-à-dire en direction de l'extérieur du détecteur d'orage 1. La portion 32a de l'excroissance 32, située du côté du bord 27a présente sensiblement une forme de demi-tore. La portion opposée 32b de l'excroissance est sensiblement plane. La forme de l'excroissance 32 permet à une goutte glissant sur le bord 27a de tomber rapidement de la collerette 27, ce qui évite de perturber les lignes de champ électrostatique. Un dispositif de chauffage 29 annulaire est inséré dans la collerette 27. Le dispositif de chauffage 29 permet notamment de dégivrer le dispositif 1 par temps froid, et plus généralement de maintenir une température de fonctionnement optimale aux basses températures. Le dispositif de chauffage 29 permet également de favoriser l'écoulement libre de l'eau en cas de pluie givrante, ou de pluie à température ambiante négative.

La géométrie de l'écran 5 et de ses lumières L présente l'avantage de couvrir en permanence une part importante de la platine 3 et des électrodes E, ce qui limite fortement la quantité de pluie susceptible de tomber dans le dispositif 1. De plus, la rotation de l'écran 5 a pour effet que les gouttes d'eau sont envoyées vers l'extérieur contre la collerette 27 annulaire par la force centrifuge. De plus, l'écran 5 est robuste, car, contrairement aux moulins à champ connus, il ne comporte pas de pale ou équivalent. Il est ainsi capable de recevoir la grêle sans être endommagé ou détruit. La régulation de sa rotation peut en outre être plus précise du fait d'un module d'inertie plus important que les systèmes à pales classiques.

Le dispositif 1 comporte une unité centrale (non représentée), qui est par exemple disposée à l'intérieur de l'enveloppe 2. L'unité centrale comporte des moyens de traitement du signal et des moyens de commande de la rotation de l'écran.

L'unité centrale dispose d'un protocole d'échange, et permet le paramétrage du fonctionnement des moyens de mesure, le contrôle de leur fonctionnement, l'affichage de l'état du dispositif 2, l'affichage en continu de la valeur du champ électrostatique, le signalement du franchissement de différents niveaux d'alerte et la mise en mémoire des données provenant des moyens de mesure.

Le dispositif 1 comporte des moyens d'alimentation 30 (figure 5), par exemple un système d'alimentation sans coupure (UPS) apte à délivrer une tension régulée de 24 V et 5A/H avec une autonomie de 10 heures.

On va maintenant décrire le fonctionnement du dispositif 1 pendant une révolution de l'écran 5.

On part d'un état initial dans lequel les électrodes E du premier groupe, c'est-à-dire les électrodes $E_1$, $E_3$, $E_5$, $E_7$, $E_9$ et $Z_{11}$, sont complètement découvertes. Pendant une première phase, le déplacement de l'écran 5 par rapport à la platine 3 a pour effet de recouvrir progressivement les électrodes $E_1$, $E_3$, $E_5$, $E_7$, $E_9$ et $E_{11}$, c'est-à-dire que la surface de chaque électrode $E_1$, $E_3$, $E_5$, $E_7$, $E_9$ et $E_{11}$ du premier groupe d'électrodes soumise au champ électrostatique atmosphérique diminue progressivement. Pendant la première phase les électrodes E du deuxième groupe, c'est-à-dire les électrodes $E_2$, $E_4$, $E_6$, $E_8$, $E_{10}$ et $E_{12}$, sont entièrement recouvertes par l'écran 5, c'est-à-dire qu'elles sont isolées du champ électrostatique. Pendant une deuxième phase, l'écran découvre progressivement les électrodes $E_2$, $E_4$, $E_6$, $E_s$, $E_{10}$ et $E_{12}$ du deuxième groupe d'électrodes, jusqu'à ce que les électrodes du deuxième groupe se trouvent respectivement au droit des lumières L. Dans cet état, les électrodes $E_2$, $E_4$, $E_6$, $E_8$, $E_{10}$ et $E_{12}$ du deuxième groupe d'électrodes sont entièrement découvertes. Pendant la deuxième phase, les électrodes $E_1$, $E_3$, $E_5$, $E_7$, $E_9$ et $E_{11}$ du premier groupe d'électrodes sont entièrement recouvertes par l'écran 5. Pendant une troisième phase, l'écran découvre progressivement les électrodes $E_1$, $E_3$, $E_5$, $E_7$, $E_9$ et $E_{11}$ du premier groupe d'électrodes, jusqu'à ce que les électrodes $E_1$; $E_3$, $E_5$, $E_7$, $E_9$ et $E_{11}$ du premier groupe d'électrodes se trouvent respectivement au droit des lumières L, ce qui correspond à l'état initial. Pendant la troisième phase, les électrodes $E_2$, $E_4$, $E_6$, $E_8$, $E_{10}$ et $E_{12}$ du deuxième groupe d'électrodes sont entièrement recouvertes par l'écran 5.

En première approximation, c'est-à-dire en négligeant, notamment, les phénomènes de diffraction, la charge reçue à un instant donné d'une électrode E est proportionnelle à la surface de l'électrode E découverte par l'écran 5. Ainsi, le déplacement des lumières L et des zones pleines du disque 31 au-dessus de l'électrode E entraîne une variation de la charge de l'électrode E. En d'autres termes, le signal transmis à l'unité centrale provenant d'une électrode E est un signal modulé m modulé par la rotation de l'écran 5. On notera que, à chaque instant, la charge reçue de chaque électrode $E_1$, $E_3$, $E_5$, $E_7$, $E_9$, $E_{11}$ du premier groupe d'électrodes (respectivement par chaque électrode $E_2$, $E_4$, $E_6$, $E_8$, $E_{10}$, $E_{12}$ du deuxième groupe d'électrodes) est identique.

Pour déterminer le signal modulé m, il faut donc déterminer la surface de l'électrode E découverte en fonction du temps. Pour cela, on réalise un produit de convolution entre la surface e de l'électrode E et la surface s de la lumière L. Les surfaces e et s sont des fonctions qui peuvent être exprimées en fonction de coordonnées polaires p et θ dans un repère prédéfini. On notera que les coordonnées p et θ dépendent du temps t puisque l'écran 5 est en mouvement. Le signal m est donc de la forme :

$$m(\rho,\theta) = e(\rho,\theta) * s(\rho,\theta)$$

Pour faciliter la réalisation de ce calcul, il est possible d'utiliser des transformées de Fourier. La transformée de Fourier du signal modulé m est de la forme :

$$M(s) = E(R,\Omega) \times S(R,\Omega)$$

où $E(R,\Omega)$ est la transformée de Fourier de $e(p,\theta)$ et $5(R,\Omega)$ est la transformée de Fourier de $s(p,\theta)$.

La forme des lumières L peut ainsi être choisie de manière à obtenir un signal m de la forme souhaitée. Par exemple, la forme des lumières L est choisie telle que le signal m soit sensiblement sinusoïdal, ce qui permet d'éviter un filtrage complexe des harmoniques. Une solution possible pour obtenir un signal m sensiblement sinusoïdal consiste à utiliser des lumières L de forme arrondie dont le diamètre est environ égal à 1,2 à 1,3 fois le diamètre de la projection d'une électrode E dans le plan de l'écran 5. Il est bien évident que l'amplitude du signal m dépend également du champ électrostatique atmosphérique.

On notera que la géométrie de l'écran 5 permet en outre de donner aisément aux lumières L une forme complexe correspondant à la fonction de modulation souhaitée sans rencontrer les limites de rigidité des hélices traditionnelles.

Les signaux provenant des électrodes $E_1$, $E_3$, $E_5$, $E_7$, $E_9$ et $E_{11}$ du premier groupe d'électrodes et des électrodes $E_2$, $E_4$, $E_6$, $E_8$, $E_{10}$ et $E_{12}$ du deuxième groupe d'électrodes sont appliqués en entrée d'un amplificateur différentiel de l'unité centrale pour détecter le sens, positif ou négatif, du champ électrostatique.

Cela permet à l'unité centrale de détecter un changement de signe du champ électrostatique, qui est une des caractéristiques de l'approche d'un orage.

Lorsque l'unité centrale a détecté un changement de signe et le dépassement d'un seuil du champ électrostatique, elle peut commander, par exemple, le déclenchement d'une alarme, l'arrêt d'une machine, ou autre.

Bien que l'invention ait été décrite en relation avec un mode de réalisation particulier, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Dispositif (1) de détection d'orage comportant au moins une paire d'électrodes de mesure ($E_1$ à $E_{12}$) du champ électrostatique atmosphérique, un écran rotatif (5), apte à soumettre simultanément chaque électrode de ladite au moins une paire d'électrodes au champ électrostatique atmosphérique puis à isoler simultanément chaque électrode de ladite au moins une paire d'électrodes du champ électrostatique atmosphérique, et une unité centrale apte à traiter des signaux provenant desdites électrodes pour déterminer un éventuel risque d'orage, ledit écran rotatif comportant un disque (3 1) présentant des lumières ($L_1$ à $L_6$) aptes à découvrir lesdites électrodes pendant une portion d'une révolution dudit écran rotatif pour les soumettre au champ électrostatique atmosphérique, et comportant une platine (3) et plusieurs paires d'électrodes ($E_1$ à $E_{12}$) disposées en cercle sur ladite platine, deux électrodes d'une paire d'électrodes étant diamétralement opposées et connectées électriquement, **caractérisé en ce que** ladite platine (3) a la forme d'un cône dont le sommet est dirigé vers ledit écran rotatif (5).

2. Dispositif selon la revendication 1, **caractérisé en ce que** ladite platine (3) comporte une rainure annulaire (25) s'étendant le long de la base du cône.

3. Dispositif selon la revendication 1 ou 2, **caractérisé en ce qu'**il comporte un cylindre de protection (26) entourant lesdites électrodes ($E_1$ à $E_{I2}$) et ledit écran rotatif (5).

4. Dispositif selon la revendication 3, **caractérisé en ce qu'**un espace (28) est prévu entre ledit cylindre de protection (26) et ladite platine (3) pour permettre l'écoulement d'eau.

5. Dispositif selon la revendication 3 ou 4, **caractérisé en ce que** ledit cylindre de protection (26) comporte une collerette (27) en forme de portion de tore, le rapport entre le diamètre du tore et le diamètre intérieur dudit cylindre de protection étant compris entre 0'18 et 0'30.

6. Dispositif selon la revendication 5, **caractérisé en ce qu'**il comporte un dispositif de chauffage (29) disposé dans ladite collerette (27).

7. Dispositif selon l'une quelconque des revendications 1 à 6, **caractérisé en ce que** ledit écran rotatif (5) est entraîné en rotation par un moteur (12) comportant des capteurs à effet Hall (13, 14, 15).

8. Dispositif selon la revendication 1, **caractérisé en ce que** la projection d'au moins une électrode ($E_1$ à $E_{12}$) dans le plan dudit écran rotatif (5) a une forme sensiblement arrondie, le rapport entre le rayon de ladite lumière ($L_1$ à $L_6$) et le rayon de ladite projection étant compris entre 1,20 et 1,30.

9. Dispositif selon l'une quelconque des revendications 1 à 4, **caractérisé en ce qu'**au moins une électrode ($E_1$ à $E_{12}$) a sensiblement la forme d'un cône dont le sommet est dirigé vers ledit écran rotatif (5).

10. Dispositif selon la revendication 5, **caractérisé en ce que** l'angle du cône est compris entre 150' et 180".

## Patentansprüche

1. Gewittererkennungsvorrichtung (1), umfassend mindestens ein Paar Messelektroden ($E_1$ bis $E_{12}$) des elektrostatischen Felds der Atmosphäre, einen Rotationsschirm (5), der imstande ist, jede Elektrode des mindestens einen Elektrodenpaars dem elektrostatischen Feld der Atmosphäre gleichzeitig auszusetzen und dann jede Elektrode des mindestens einen Elektrodenpaars des elektrostatischen Felds der Atmosphäre gleichzeitig zu isolieren, und eine Zentraleinheit, die imstande ist, die von den Elektroden kommenden Signale zu verarbeiten, um ein eventuelles Gewitterrisiko zu bestimmen, wobei der Rotationsschirm eine Scheibe (31) mit Öffnungen ($L_1$ bis $L_6$) aufweist, die imstande sind, die Elektroden während eines Abschnitts einer Umdrehung des Rotationsschirms freizugeben, um sie dem elektrostatischen Feld der Atmosphäre auszusetzen, und eine Platte (3) und mehrere Elektrodenpaare ($E_1$ bis $E_{12}$), die auf der Platte im Kreis angeordnet sind, wobei zwei Elektroden eines Elektrodenpaars diametral gegenüberliegen und elektrisch verbunden sind, **dadurch gekennzeichnet, dass** die Platte (3) die Form eines Kegels hat, dessen Spitze zum Rotationsschirm (5) zeigt.

2. Vorrichtung nach Anspruch 1, **dadurch gekennzeichnet, dass** die Platte (3) eine ringförmige Rille (25) aufweist, die sich entlang der Basis des Kegels erstreckt.

3. Vorrichtung nach Anspruch 1 oder 2, **dadurch gekennzeichnet, dass** sie einen Schutzzylinder (26) aufweist, der die Elektroden ($E_1$ bis $E_{12}$) und den Rotationsschirm (5) umgibt.

4. Vorrichtung nach Anspruch 3, **dadurch gekennzeichnet, dass** zwischen dem Schutzzylinder (26) und der Platte (3) ein Raum (28) vorgesehen ist, um das Abfließen von Wasser zu erlauben.

5. Vorrichtung nach Anspruch 3 oder 4, **dadurch gekennzeichnet, dass** der Schutzzylinder (26) einen Ring (27) in Form eines Torusabschnitts aufweist, wobei das Verhältnis zwischen dem Durchmesser des Torus und dem Innendurchmesser des Schutzzylinders zwischen 0'18 und 0'30 inklusive ist.

6. Vorrichtung nach Anspruch 5, **dadurch gekennzeichnet, dass** sie eine Heizvorrichtung (29) aufweist, die in dem Ring (27) angeordnet ist.

7. Vorrichtung nach einem der Ansprüche 1 bis 6, **dadurch gekennzeichnet, dass** der Rotationsschirm (5) von einem Motor (12) rotierend angetrieben wird, der Sensoren mit Hall-Effekt (13, 14, 15) aufweist.

8. Vorrichtung nach Anspruch 1, **dadurch gekennzeichnet, dass** die Projektion mindestens einer Elektrode ($E_1$ bis $E_{12}$) in der Ebene des Rotationsschirms (5) eine etwa abgerundete Form hat, wobei das Verhältnis zwischen dem Radius der Öffnung ($L_1$ bis $L_6$) und dem Radius der Projektion zwischen 1,20 und 1,30 inklusive ist.

9. Vorrichtung nach einem der Ansprüche 1 bis 4, **dadurch gekennzeichnet, dass** mindestens eine Elektrode ($E_1$ bis $E_{12}$) etwa die Form eines Kegels hat, dessen Spitze zum Rotationsschirm (5) zeigt.

10. Vorrichtung nach Anspruch 5, **dadurch gekennzeichnet, dass** der Winkel des Kegels zwischen 150' und 180" inklusive ist.

## Claims

1. A storm detection device (1) including at least one pair of measuring electrodes ($E_1$ to $E_{12}$) for measuring the atmospheric electrostatic field, a rotating screen (5), able to subject each electrode of said at least one pair of electrodes simultaneously to the atmospheric electrostatic field, then to simultaneously isolate each electrode of said at least one pair of electrodes from the atmospheric electrostatic field, and a central processing unit able to process signals from said electrodes to determine a potential storm risk, said rotating screen including a disc (31) having apertures ($L_1$ to $L_6$) able to expose said electrodes during a portion of a revolution of said rotating screen to subject them to the atmospheric electrostatic field, and including a platen (3) and several pairs of electrodes ($E_1$ to $E_{12}$) arranged in a circle on said platen, two electrodes of a pair of electrodes being diametrically opposite and electrically connected, **characterized in that** said platen (3) is in the shape of a cone whereof the apex is oriented toward said rotating screen (5).

2. The device according to claim 1, **characterized in that** said platen (3) includes an annular slot (25) extending along the base of the cone.

3. The device according to claim 1 or 2, **characterized in that** it includes a protective cylinder (26) surrounding said electrodes ($E_1$ to $E_{12}$) and said rotating screen (5).

4. The device according to claim 3, **characterized in that** a space (28) is provided between said protective cylinder (26) and said platen (3) to allow the flow of water.

5. The device according to claim 3 or 4, **characterized in that** said protective cylinder (26) includes a collar (27) in the shape of a toroid portion, the ratio between the diameter of the toroid and the inner diameter of said protective cylinder being comprised between 0'18 and 0'30.

6. The device according to claim 5, **characterized in that** it includes a heating device (29) arranged in said collar (27).

7. The device according to any one of claims 1 to 6, **characterized in that** said rotating screen (5) is rotated by a motor (12) including Hall effect sensors (13, 14, 15).

8. The device according to claim 1, **characterized in that** the projection of at least one electrode ($E_1$ to $E_{12}$) in the plane of said rotating screen (5) has a substantially rounded shape, the ratio between the radius of said aperture ($L_1$ to $L_6$) and the radius of said projection being comprised between 1:20 and 1:30.

9. The device according to any one of claims 1 to 4, **characterized in that** at least one electrode ($E_1$ to $E_{12}$) is substantially in the shape of a cone whose apex is oriented toward said rotating screen (5).

10. The device according to claim 5, **characterized in that** the angle of the cone is comprised between 150' and 180".

Fig. 1

Fig. 7

Fig. 6

Fig. 2

Fig. 3

Fig. 4

EP 2 041 586 B1

Fig. 5

10

EP 2 041 586 B1

Fig. 8

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2432719

- FR 1400352